# EUROPÄISCHE PATENTANMELDUNG

(11) **EP 1 406 316 A2**
(43) Veröffentlichungstag der Anmeldung: **07.04.2004**
(21) Anmeldenummer: 03021918.2
(22) Anmeldetag: 29.09.2003
(51) Int. Cl.: H01L 37/02

(54) **Pyroelektrischer Keramik-Film**

(30) Priorität: 05.10.2002 DE 10246584
(71) Anmelder: Fachhochschule Kiel, 24149 Kiel (DE)
(72) Erfinder: Es-Souni, Mohammed, 24149 Kiel (DE)
(74) Vertreter: Biehl, Christian, Dipl.-Phys.

(57) **Zusammenfassung**

Pyroelektrischer Keramik-Film mit wenigstens zwei in direktem Kontakt stehenden, übereinander angeordneten, sich wenigstens in ihrer Stöchiometrie unterscheidenden Schichten, wobei wenigstens eine der Schichten Erbium enthält, wobei die oder eine der äußeren Schichten pyroelektrisch ist und die bzw. eine der weiteren Schichten Erbium enthält.

## Beschreibung

Die Erfindung betrifft einen auf ein Substrat aufgebrachten pyroelektrischen Keramik-Film mit den Merkmalen des Oberbegriffs des Anspruchs 1.

Es sind eine Vielzahl pyroelektrischer Materialien bekannt, insebsondere monokristalline Metalloxide, z.B. Lithiumtantalat (LiTaO₃) oder Strontiumbariumniobat Sr(BaₓNb₁₋ₓ)O₃, kurz: SBN) (A. J. Moulsen and J. M. Herbert, Electroceramics, Chapman & Hall, London, 318-328, 1990).

Der pyroelektrische Koeffizient p ist definiert für Kristalle mit Spontanpolarisation - in Abwesenheit eines äußeren Feldes - als Änderung der Polarisation mit der Temperatur. Eine Maßzahl für die Qualität eines Pyroelektrikums ist die so genannte Güte **M** (engl.: *figure of merit*), die in der Literatur auf verschiedene Weise definiert wird. Allen Definitionen gemein ist, dass **M** proportional zu **p** und invers proportional zum Wärmespeichervermögen (der spezifischen Wärme) und zum Absorptionsvermögen des Materials für elektromagnetische Strahlung (loss function) erklärt ist und idealerweise einen großen Wert annehmen sollte.

Da alle Pyroelektrika zugleich relativ hohe Dielektrizitätskonstanten (DK) besitzen-schon deshalb, weil es sich dabei meist auch um Ferroelektrika handelt, bei denen sich Dipoldomänen ausbilden -, zieht die Materialantwort auf elektrische Wechselfelder i. a. hohe Absorptionsverluste bei der Bewegung der Elementardipole (durch Dissipation von Wärme) nach sich, die es möglichst zu minimieren gilt. Die wohl am weitesten verbreitete Anwendung pyroelektrischer Kristalle liegt in der Fertigung von Infrarot-Sensoren.

Neben Einkristallen kennt der Stand der Technik auch polykristalline Schichten aus pyroelektrischen Keramiken, die auf Substrate aufgetragen werden. Zu den gängigsten Methoden ihrer Herstellung zählt das Sol-Gel-Verfahren (K. D. Budd, S. K. Dey, D. A. Payne, *Brit.* Ceram. Proc., **36**, 107 ff., 1985). Dabei werden zuerst die metallischen Komponenten der späteren Metalloxid-Beschichtung als organische Moleküle (typisch: Metallalkoholat, Metallsalze) in einem geeigneten Lösungsmittel (zum Beispiel Essigsäure oder Methoxyethanol oder einem Gemisch aus diesen) in den gewünschten Massenverhältnissen vermischt. In einem solchen als Sol bezeichneten Gemisch können die Metallalkoholate durch Zugabe von Wasser hydrolysiert werden.

Damit die Metalle nicht aus der Lösung ausfallen, ist das Sol zuerst zu stabilisieren, z.B. durch Zugabe von Acetylaceton, Essigsäure oder Diethyleneamin. Die teilweise hydrolysierten Alkoholate können langkettige Makromoleküle (Polymerisation) bilden, und bei Entzug des Lösungsmittels bildet sich ein organisches Gel, in dem alle Teilchen miteinander verbunden sind (hohe Viskosität).

Das Aufbringen der keramischen Schichten erfolgt dann durch Aufschleudern des Gels auf hochreine Substrate (z.B. platiniertes Silizium, Aluminiumoxyd, Tantalaluminat (LaAlO₃), Glas, Metallsubstrate). Das aufgebrachte Material wird schließlich zur Entfernung des Lösungsmittels auf mehrere 100°C erhitzt und in vielen Fällen bei Temperaturen bis 1000°C noch gesintert, um möglichst gleichmäßige Schichten zu erzielen.

Aus dem Aufsatz Pintilie und Constantin (Ferroelectrics, **173**, 111-124, 1995) ist ferner bekannt, dass das Kontaktieren verschiedener piezoelektrischer Keramiken zu Heterostrukturen führt, deren elektrische Eigenschaften sich wesentlich von denen der Konstituenten unterscheiden können. Am konkreten Beispiel von Bleilanthanzirkonattitanat (PLZT) mit verschiedenen weiteren Dotierungen weisen die Autoren insbesondere nach, dass sich eine Heterostruktur herstellen lässt, die mit 540 µC/m²K einen wesentlich höheren pyroelektrischen Koeffizienten besitzt als jede der Einzelkomponenten (hier 360 bzw. 430 µC/m²K) für sich genommen.

Die Dielektrizitätskonstante der Heterostruktur liegt zudem zwischen denen der Einzelschichten (und deutlich näher am niedrigeren Wert), weil es sich beim Kontaktieren zweier Dielektrika im Prinzip um eine Reihenschaltung von Kondensatoren handelt. Daraus folgt, dass die pyroelektrische Güte solcher Heterostrukturen in derselben Größenordnung liegen kann wie die Güte pyroelektrischer Einkristalle.

Das kostspielige Züchten und Bearbeiten von Einkristallen kann hiernach durch den heterogenen Aufbau aus polykristallinen Keramikschichten wesentlich vereinfacht werden, ohne dass signifikante Einbußen in den pyroelektrischen Eigenschaften in Kauf zu nehmen sind. Außerdem erlaubt der schichtweise Aufbau des Pyroelektrikums zugleich die Anwendung von Beschichtungstechniken, z.B. des Sol-Gel-Verfahrens, zur Erzeugung von Funktionsschichten auf fast beliebigen Substraten.

Pintilie und Pintilie (Ferroelectrics, **200**, 219-235, 1997) geben an, dass das Verhalten der Heterostruktur nach Pintilie und Constantin (1995) wesentlich vom Ladungsaustausch über die Grenzfläche zwischen den in direktem Kontakt befindlichen keramischen Schichten bestimmt wird.

Aus der Druckschrift CN 1342783 sind zudem mehrschichtige PZT-Filme bekannt, bei denen das Zr/Ti-Verhältnis durch die Schichten hindurch einen Gradienten aufweist. Die Filme bestehen aus drei oder mehr Schichten und werden in einem Sol-Gel-Prozeß hergestellt. Eine mögliche Anwendung solcher Filme liegt in der Fertigung nicht-gekühlter Infrarot-Sensoren.

Aus der DE 43 39 401 und der EP 0 805 271 A1 sind weitere Schichtstrukturen bekannt, die mit Erbium dotiert sind bzw. Erbiumoxid enthalten.

Es ist die Aufgabe der Erfindung, einen keramischen Film zu schaffen, der eine möglichst hohe pyroelektrische Güte aufweist.

Diese Aufgabe wird durch die Merkmale des Anspruchs 1 gelöst, die Unteransprüche geben vorteilhafte Ausgestaltungen an.

Die Erfindung betrifft also die Materialauswahl und die geometrische Anordnung der Materialien im Film. Durch die Verwendung eines mit Erbium dotierten Metalloxidschicht werden die elektrischen Eigenschaften des Films deutlich stabilisiert. Diese begünstigende Wirkung von Erbium ist Kernstück der Erfindung..

Zum Erzeugen von infrarotsensitiven Filmen ist es zweckmäßig, das Pyroelektrikum auf der dem Substrat abgewandten Seite des Films als Außenschicht anzuordnen. In speziellen Fällen kann es zudem sinnvoll sein, eine weitere für Licht, insbesondere für Infrarotlicht, transparente Schutzschicht (z.B. ein Aluminiumoxid) vor dem Pyroelektrikum anzuordnen, etwa zur Abwehr aggressiver Atmosphären. Es empfiehlt sich weiterhin, zwischen dem Pyroelektrikum und dem den Film tragenden Substrat wenigstens eine Metalloxidschicht mit möglichst niedriger Dielektrizitätskonstante anzuordnen.

Es ist zweckmäßig, die vorgenannten Metalloxidschichten ebenfalls in Kontakt zueinander anzuordnen. Dies lässt sich bevorzugt beim Sol-Gel-Verfahren durch mehrfaches Wiederholen von Beschichtungsschritten erreichen, die im wesentlichen aus dem Aufschleudern (Spincoating) eines Gels mit anschließendem Erhitzen zur Kristallisation bestehen. Durch den Wechsel des Gels im Verlauf des Verfahrens entsteht die gewünschte Struktur.

Der besagte Ladungsaustausch ist gemeinhin mit Ionendiffusion über die Grenzfläche hinweg verbunden, wie dies für das nachfolgende Ausführungsbeispiel nachweisbar ist. Aufgrund der Ionendiffusion entsteht in der Umgebung der Grenzfläche eine lokal begrenzte Mischstruktur mit zunächst unbekannter stöchiometrischer Zusammensetzung und Ausdehnung senkrecht zur Grenzfläche. Dabei ist es vorteilhaft, die Metalloxidschichtdicken der erfindungsgemäßen Heterostruktur ausreichend groß einzurichten, damit das Entstehen der Mischstruktur an der Grenzfläche nicht durch den Einfluss anderer nahe gelegener Schichtgrenzen beeinträchtigt wird.

Diese Mischstruktur ist hauptsächlich verantwortlich für den außergewöhnlich hohen pyroelektrischen Koeffizienten, der sich an dem Film messen lässt. Zugleich weist der Film eine geringe Dielektrizotätskonstate und somit eine sehr hohe pyroelektrische Güte auf.

In der beiliegenden Zeichnung werden Ausführungsbeispiele der Erfindung angegeben. Dabei zeigt:
- Fig. 1: ein Ablaufdiagramm der Herstellung des Sols für Erbium-dotiertes Bleititanat (PET),
- Fig. 2: ein Ablaufdiagramm der Herstellung des Sols für Fe- und Nb-modifiziertes Blei-Zirkonat-Titanat (PZFNT), und
- Fig. 3 in: tabellarischer Form die Herstellung des mehrschichtigen Films aus PET (untere Schicht) und PZFNT (obere Schicht).

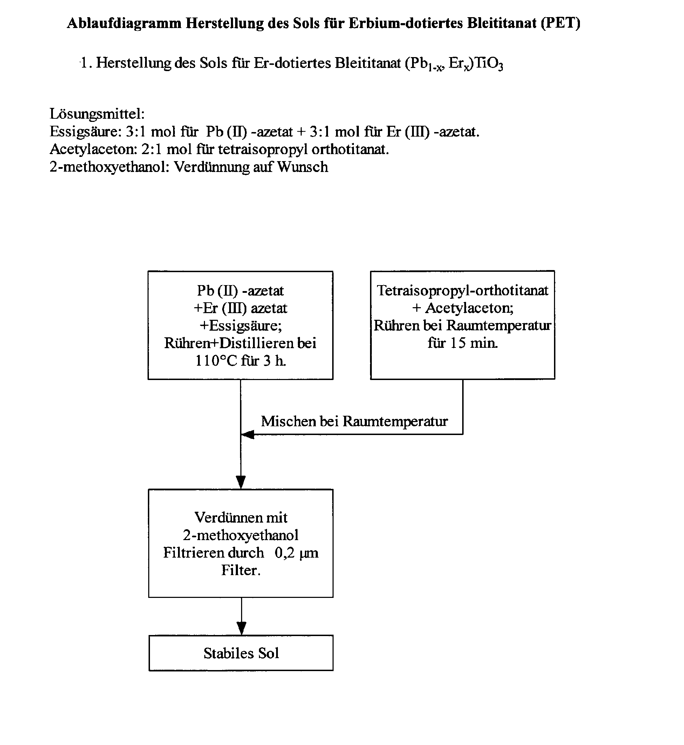

In der Fig. 1 wird anhand eines Ablaufdiagramms das Mischen bei Raumtemperatur der beiden Ausgangsmaterialien nämlich Blei(II)-Azetat und Erbium(III)-Azetat, die durch Rühren mit Essigsäure und Destillieren bei 110° C für 2 Stunden einerseits erreicgt wurden und andererseits Tetraisopropyl-Orthotitanat und Acetylaceton das bei Raumtemperatur für 15 Minuten gerührt wurde, dargestellt. Anschließendes Verdünnen mit 2-Methoxyethanol und Filtrieren durch einen 0,2 µm Filter ergibt ein stabiles Sol für Erbium-dotiertes Bleititanat (Pb₁₋ₓ, Erₓ)TiO₃.

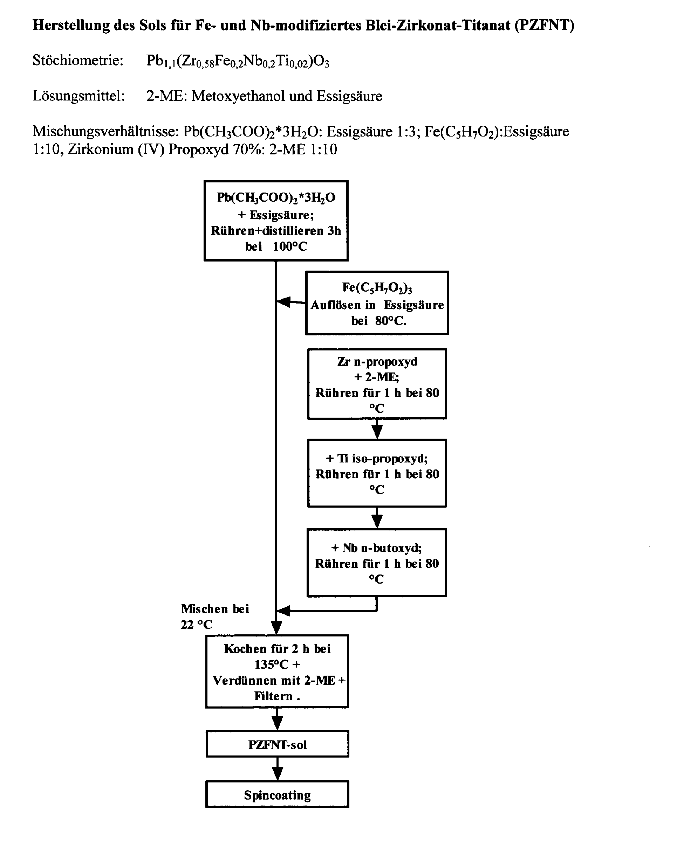

Fig. 2 zeigt Herstellung des Sols für Fe- und Nb-modifiziertes Blei-Zirkonat-Titanat (PZFNT) mit der Stöchiometrie: Pb_{1,1}(Zr_{0,58}Fe_{0,2}Nb_{0,2}Ti_{0,02})O₃ wobei mit zunächst Pb(CH₃COO)₂*3H₂O mit Essigsäure im Mischungsverhälnis 1:3 gerührt und anschließend destillert wird; dann Fe(C₅H₇O₂) mit Essigsäure 1:10 hinzugegeben wird; und dann Zirkon (IV)-n-Propoxyd 70%: nach Rühren mit dem Lösungsmittel: 2-ME: Metoxyethanol und Essigsäure im Verhältniss 1:10 und Zugabe von Titan Iso-Propoxyd und Niob N-Butoxyd hinzugegeben und vermischt werden (bei Raumtemperatur). Kochen der Mischung für 2 Stunden bei 135° C und Verdünnen mit 2ME ergibt nach einem Filtern PZFNT-Sol, das zum Soincoating verwandt werden kann.

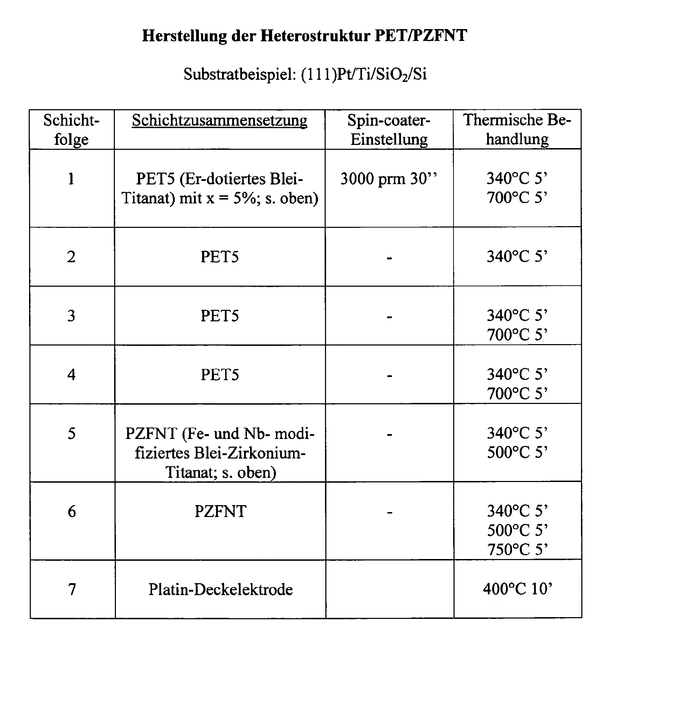

Fig. 3 zeigt die Herstellung der Schichtfolgen einer Heterostruktur PET/PZFNT am Substratbeispiel (111)Pt/Ti/SiO₂/Si. Einer ersten Schicht PET5 folgen drei weitere wobei die erste und die beiden letzten nicht nur einer termischen Behandlung von 340° C für 5 Minuten sondern ebensolang auch einer erhöhtem Temperatur von 700°C ausgesetzt werden. Zwei Schichten PZFNT von denen die zweite neben zwei thermischen Behandlungen bei 340°C und 700°C für je 5 Minuten auch noch dazwischen 5 Minuten bei 500°C gehalten wird, folgt eine Platin Deckeleletrode, die für 10 Minuten bei 400° C thermisch behandelt wird.

## Patentansprüche

1. Pyroelektrischer Keramik-Film mit wenigstens zwei in direktem Kontakt stehenden, übereinander angeordneten, sich wenigstens in ihrer Stöchiometrie unterscheidenden Schichten, wobei wenigstens eine der Schichten Erbium enthält, **dadurch gekennzeichnet, dass** die oder eine der äußeren Schichten pyroelektrisch ist und die bzw. eine der weiteren Schichten Erbium enthält.

2. Kermischer Film nach Anspruch 1, **dadurch gekennzeichnet, dass** die pyroelektrische Schicht die Außenschicht ist.

3. Keramischer Film nach den Ansprüchen 1, **dadurch gekennzeichnet, dass** die pyroelektrische Schicht nach außen von einer für Licht, insbesondere Infrarotlicht, durchlässige Schicht abgedeckt ist.

4. Keramischer Film nach einem der vorangegangenen Ansprüche, **dadurch gekennzeichnet, dass** jede der Schichten mehr als 50 nm dick ist.

5. Keramischer Film nach einem der vorangegangenen Ansprüche, **dadurch gekennzeichnet, dass** wenigstens eine der Metalloxidschichten aus mit Erbium dotiertem Bleititanat der Stöchiometrie (Pb₁₋ₓ,Erₓ)Ti O₃ mit x=0 bis 10% besteht.

6. Keramischer Film nach einem der Ansprüche 2 oder 3, **dadurch gekennzeichnet, dass** die pyroelektrische Schicht aus mit Eisen und Niob dotiertem Bleizirkonattitanat (PZT) der Stöchiometrie Pb (Zr_{1-x-y-z} Feₓ Nb_{y} Ti_{z}) O₃ mit x=0 bis 20%, y= 0 bis 20%?, z=0 bis 20% besteht.

7. Verwendung eines keramischen Films nach einem der vorangehenden Ansprüche zur Herstellung eines Infrarot-Sensors.
